# EUROPEAN PATENT APPLICATION

(11) **EP 0 588 651 A1**
(43) Date of publication of application: **23.03.1994**
(21) Application number: 93307340.5
(22) Date of filing: 16.09.1993
(51) Int. Cl.: H01L 23/498, H01L 23/64

(54) **Ceramic microwave packages**

(30) Priority: 17.09.1992 GB 9219661
(71) Applicant: OXLEY DEVELOPMENTS CO., LTD., Ulverston Cumbria LA12 9QG (GB)
(72) Inventor: North, Stephen John, Ulverston, Cumbria LA12 7NQ (GB); Edwards, Geoffrey Stephen, Grange Over Sands, Cumbria LA11 7QB (GB)
(74) Representative: W.P. Thompson & Co.

(57) **Abstract**

A ceramic microwave package, in which connections to a thin-film circuit pattern (26) are made through a flat ceramic substrate (14) by way of integral, impedance matched, co-fired vias (12, 19) and in that the periphery of a metal trough-shaped lid (22) is connected directly to the flat ceramic substrate (14), outboard of the thin-film circuit pattern.

## Description

The present invention relates to ceramic packages and package components for the housing and protection of semi-conductor chips.

Hermetic packages provide the necessary environmental protection for semi-conductor chips to ensure reliable, long term operation of the chip. At high frequencies, packages fabricated from metals have traditionally been utilised for their inherent grounding of the metal package wall structure to ensure a good microwave performance. However, recently, the use of ceramic packages has been preferred as they are able to provide the necessary environmental protection using a hermetically sealed package produced using so-called co-fired ceramic technology. For examples of the latter, reference is directed to our prior GB Patent No. 2182045 and pending UK Application No. 0408228.

Known structures formed using co-fired ceramic technology have comprised a base portion and an upstanding surrounding wall on the base portion, the upper surface of the wall being provided with an electrically conductive coating in order to receive a lid sealingly thereon. The lid has to be earthed and this has been achieved, for example, by the use of co-fired vias which extend through the height of the wall (0408228).

However, in order to achieve operation at even higher microwave frequencies up to 60GHz and higher, ways must be sought of reducing still further the lengths of signal paths within the package and it is a primary objective of the present invention to provide significant improvements in this area. In addition, there is always a requirement for reducing further the production costs and manufacturing complexities.

In accordance with the present invention, there is provided a ceramic microwave package in which connections to a thin-film circuit pattern are made through a flat ceramic substrate by way of integral, impedance matched, co-fired vias and in which the periphery of a metal trough-shaped lid is connected directly to the flat ceramic substrate, outboard of the thin-film circuit pattern.

As a result of the latter structure, the previous necessity to form integral upstanding side walls on the substrate around the circuit area is removed.

In one embodiment, the circuit pattern can be formed by thin-film technology on a thin-film .pasubstrate which is mounted to the main ceramic substrate such as to communicate with the underside of the latter substrate by way of integral vias.

In another embodiment, the circuit pattern is formed directly on the main ceramic substrate such as to communicate with the underside of the latter substrate by way of integral vias.

The invention is described further hereinafter, by way of example only, with reference to the accompanying drawings, in which:-
Fig. 1 is a diagrammatic cross-sectional view through one embodiment of a ceramic microwave package in accordance with the present invention;
Fig. 2 is an exploded perspective view of the package of Fig. 1;
Fig. 3 is a diagrammatic cross sectional view through a second embodiment of a ceramic microwave package in accordance with the present invention; and
Fig. 4 is an exploded perspective view of the package of Fig. 3.

The described embodiments relate to packages for microwave circuits that traditionally are fabricated in thin-film circuits using specially flat and polished discrete substrates, the flat polished surface being necessary to allow high precision photolithographic techniques and the consequent achievement of the fine line definition necessary for microwave performance. These thin-film circuits are usually bonded into ceramic packages as separate units.

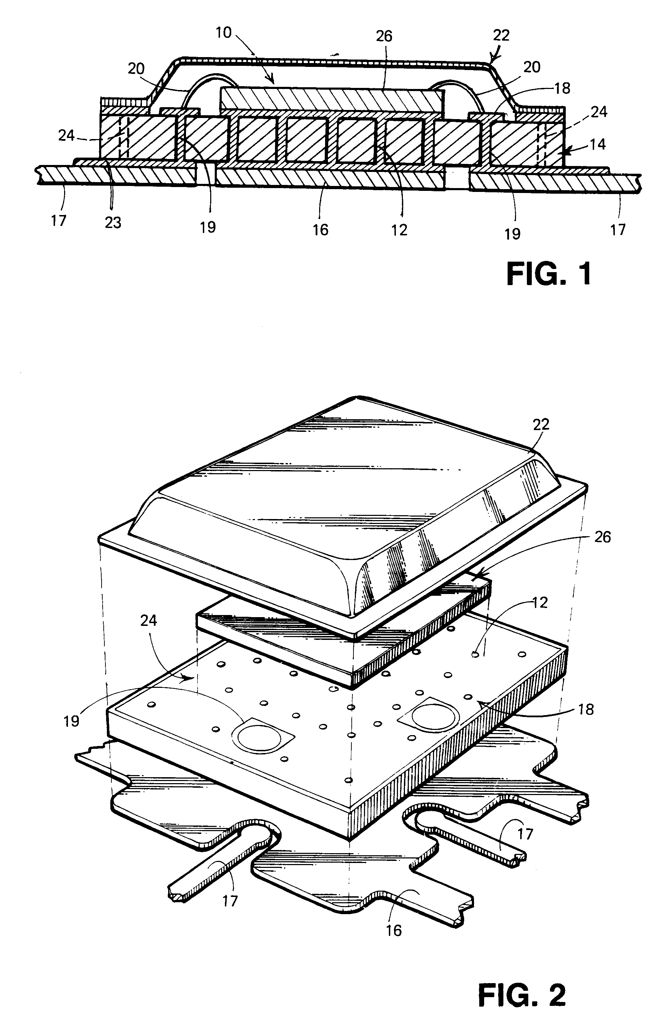

Referring now to Figs. 1 and 2, in the first embodiment in accordance with the present invention, a thin-film substrate 10, patterned with the relevant device circuit (26), is bonded directly to vias 12 which are formed integrally within a ceramic substrate 14 and which make direct connections to the conventional lead frame 16 on which the package is mounted (in use). The upper surface of the ceramic substrate 14 (as viewed in Fig. 1) carries a thick-film metallisation (usually tungsten) 18. Signal carrying connections are made via discrete fine wires 20 from the circuit on the thin-film substrate 10 to the thick-film metallisation 18 and thence to signal portions 17, in the plane of the package/lead frame 16, by way of impedance matched vias 19. A metal "top hat" lid 22 is bonded to the thick-film metallisation 18 which in turn is connected through the ceramic substrate 14 to the lead frame 16 by integral vias 24. Reference numeral 23 identifies a solder/braze joint.

The bonding of the thin-film circuit direct to the integral vias 12 which make direct contact with the lead frame 16 and the use of a metal top hat lid which makes direct contact with the thick-film metallisation 18 on the ceramic substrate 14 eliminates the need for the above mentioned conventional side walls which have to be impedance matched by wall lead-throughs and vias in the walls in order to earth the lid. The latter function is now provided by the vias 24 in the single substrate 14 with its inherently simpler manufacturing route and shorter signal paths.

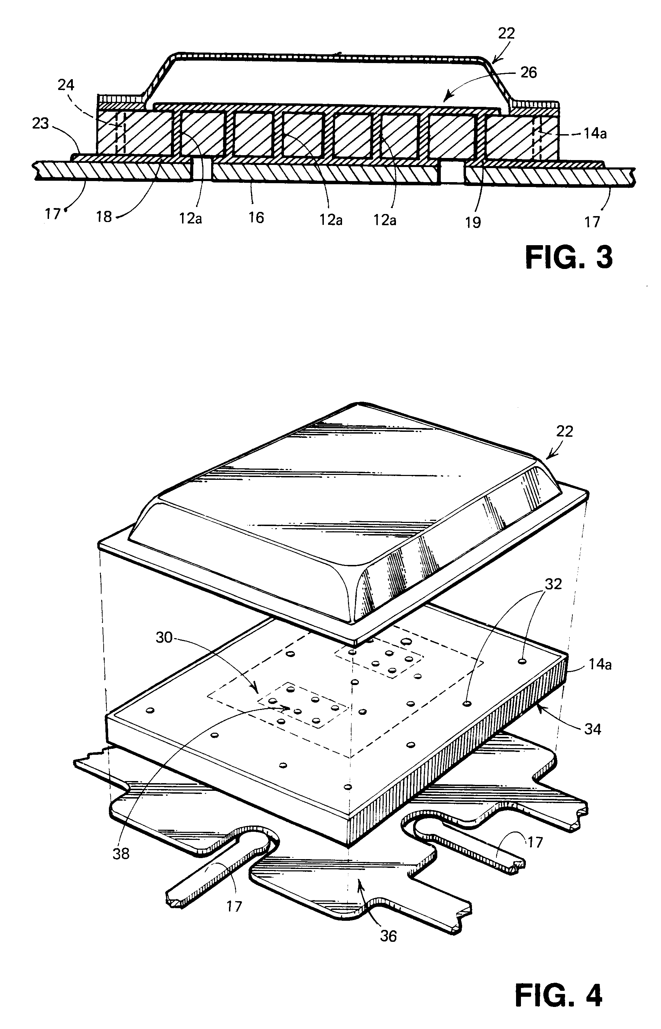

In the second embodiment of Figs. 3 and 4, a thin-film metallised circuit 26 is deposited directly onto the upper surface of the ceramic package/substrate 14a so as to further reduce costs and shorten further the signal paths. Parts which are the same in the two embodiments are given the same reference numerals. It should be noted that the upper surface of the substrate 14a should be flat and polished to accommodate the thin-film photolithographic processes and that the grinding and polishing in this case can now be carried out after the initial firing because of the elimination of side walls. Also, the fine wires 20 used in the first embodiment for bonding elements in the thin-film circuit of the signal carrying portions 17 are replaced in the second embodiment by direct connection to the vias 12a when the thin-film is deposited onto the ceramic substrate. A substantial reduction in signal paths and a consequent increased frequency performance results.

Referring further to Fig. 4, reference numeral 30 identifies an area to be metallised with a thin-film circuit; reference numeral 32 identifies examples of via interconnections which are co-fired with the ceramic substrate 14a; reference numeral 34 identifies a thick-film tungsten metallisation; reference numeral 36 indentifies solder/brazing area by which the leadframe 16 can be soldered or brazed to the plated thick film metellisation; and reference numeral 38 indicates a series of vias whose configuration and relative positioning is selected so as to maximise the grounding effect.

## Claims

1. A ceramic microwave package, characterised in that connections to a thin-film circuit pattern (26) are made through a flat ceramic substrate (14) by way of integral, impedance matched, co-fired vias (12,19) and in that the periphery of a metal trough-shaped lid (22) is connected to the flat ceramic substrate (14), outboard of the thin-film circuit pattern.

2. A ceramic microwave package according to claim 1, wherein the circuit pattern (26) is formed by thin-film technology on a thin-film substrate (20) which is mounted to a main ceramic substrate (14) and communicates with the underside of the latter substrate (14) by way of integral vias (12).

3. A ceramic microwave package according to claim 1, wherein the circuit pattern (26) is formed directly on a main ceramic substrate (14a) and communicates with the underside of the latter substrate by way of integral vias (12a).

4. A ceramic microwave package according to claim 2 or 3, wherein said underside of the main ceramic substrate (14, 14a) is connected electrically to a lead frame (16).

5. A ceramic microwave package according to claim 4 wherein the connection of the underside of the main ceramic substrate (14, 14a) to the lead frame (16) is achieved by soldering or brazing.
